# FASCICULE DE BREVET EUROPEEN

(11) **EP 4 069 630 B1**
(45) Date de publication et mention de la délivrance du brevet: **01.10.2025**
(21) Numéro de dépôt: 20828659.1
(22) Date de dépôt: 30.11.2020
(51) Int. Cl.: B81C 1/00, H01L 21/60, H01L 23/00

(54) **PROCEDE DE DEPOT LOCALISE D'UN MATERIAU SUR UN ELEMENT METALLIQUE**
VERFAHREN ZUM LOKALISIERTEN AUFBRINGEN EINES MATERIALS AUF EIN METALLELEMENT
METHOD FOR THE LOCALIZED DEPOSITION OF A MATERIAL ON A METAL ELEMENT

(30) Priorité: 02.12.2019 FR 1913629
(43) Date de publication de la demande: 12.10.2022
(73) Titulaire: Commissariat à l'Energie Atomique et aux Energies Alternatives, 75015 Paris (FR)
(72) Inventeur: FRANIATTE, Rémi, 38054 GRENOBLE Cedex 09 (FR); CHARBONNIER, Jean, 38054 GRENOBLE Cedex 09 (FR); DAVID, Nadine, 38054 GRENOBLE Cedex 09 (FR)
(74) Mandataire: Brevalex
(86) Numéro de dépôt international: PCT/FR2020/052218
(87) Numéro de publication internationale: WO 2021/111067

(56) Documents cités:
- FR-B1- 2 846 906
- US-A- 5 956 606
- US-A- 6 008 071
- US-A1- 2013 196 504
- US-A1- 2015 325 507

## Description

### DOMAINE TECHNIQUE

Ce document concerne un procédé de dépôt localisé d'au moins un matériau sur au moins un élément, appliqué notamment pour :
- la réalisation d'interconnexions électriques et/ou mécaniques, par exemple des métallisations de type billes ou microbilles fusibles, ou billes ou microbilles de brasure, sur au moins une puce électronique,
- la réalisation d'au moins un cordon de scellement sur au moins une couche de protection ou un capot destiné à fermer au moins une cavité dans laquelle se trouve par exemple au moins un composant de type MEMS (« MicroElectroMechanical System », ou microsystème électro-mécanique),
- la réalisation d'au moins une couche de fonctionnalisation pour au moins un capteur ou un dispositif de test utilisé dans le domaine de la biologie et/ou de la chimie.

### ÉTAT DE LA TECHNIQUE ANTÉRIEURE

Les puces électroniques, telles que les ASIC ou « Application-Specific Integrated Circuit », les puces mémoires, etc., commercialisées sont généralement destinées à être connectées par câblage filaire, ou « wire-bonding », et ne sont pas pourvues de métallisations de type billes fusibles, ou « solder bumps », sur leurs plots de connexion. De par leurs faibles dimensions latérales (généralement de quelques millimètres) et/ou leur faible épaisseur (généralement quelques dizaines de microns), il est très difficile de fabriquer, sur chaque puce électronique prise individuellement, des métallisations de type billes fusibles. De telles métallisations permettent de solidariser la puce électronique par « flip-chip », ou retournement, sur un élément d'interposition, ou « interposer », ou un substrat auquel la puce électronique est destinée à être couplée mécaniquement et/ou électriquement.

Pour former des métallisations de type billes fusibles sur une puce électronique, celles-ci sont généralement réalisées collectivement pour plusieurs puces électroniques simultanément, à l'échelle d'un wafer ou substrat comportant les puces électroniques. La sérigraphie est la technique la plus couramment utilisée pour réaliser des billes fusibles, car il s'agit de la technique la moins coûteuse pour traiter les puces à l'échelle du wafer.

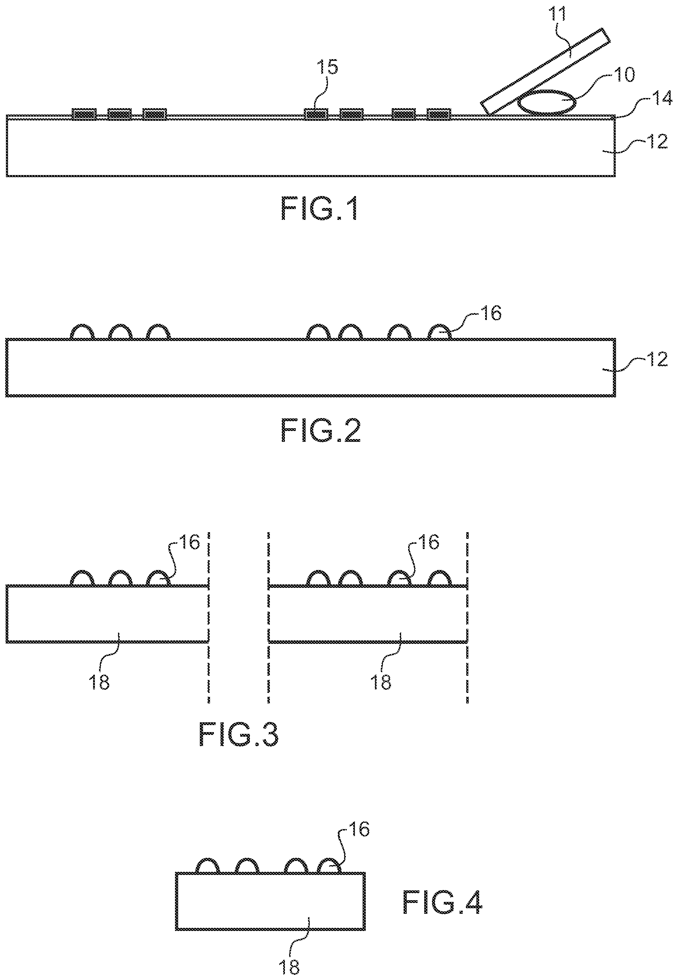

Un exemple de procédé de réalisation collective de métallisations de type billes fusibles par sérigraphie est décrit ci-dessous en lien avec les figures 1 à 4.

Comme représenté sur la figure 1, de la pâte à braser 10 comportant du matériau fusible, ou matériau métallique de brasure, est étalée sur un substrat 12 dans lequel ou sur lequel les puces ont été réalisées au préalable, du côté où les billes fusibles sont destinées à être réalisées. La pâte à braser 10 est étalée par exemple par une racle 11 à travers un écran de sérigraphie 14 ou masque de sérigraphie. Des ouvertures formées à travers l'écran de sérigraphie 14 définissent des emplacements du substrat 12 sur lesquels la pâte à braser 10 est déposée sous la forme de petites portions 15 espacées les unes des autres.

L'écran de sérigraphie 14 est ensuite retiré puis un recuit est mis en œuvre à une température supérieure ou égale à la température de fusion du matériau fusible afin que les portions 15 passent à l'état liquide puis forment, à l'issue de ce recuit et après le retour à l'état solide du matériau fusible, des billes 16 de matériau fusible (figure 2).

Une découpe du substrat 12 est ensuite mise en œuvre afin de former des puces électroniques 18 séparées les unes des autres et chacune munies de billes fusibles 16 (figure 3).

Sur la figure 4, une puce électronique 18 prête à être reportée par « flip-chip » sur un support est représentée.

Cette réalisation des billes fusibles 16 par un dépôt du matériau fusible par sérigraphie n'est pas envisageable pour des puces individuelles, c'est-à-dire à l'échelle d'une puce électronique déjà découpée sur laquelle l'écran de sérigraphie serait disposé, car elle augmenterait sensiblement le coût de réalisation des puces électroniques.

De plus, cette méthode de réalisation des billes fusibles n'est pas adaptée lorsque la surface sur laquelle les billes fusibles doivent être réalisées est irrégulière et comporte des creux car lors de l'étalement de la pâte 10, celle-ci n'est pas déposée correctement dans les creux. De plus, du fait que l'écran de sérigraphie 14 doit être plaqué contre la surface sur laquelle les billes fusibles sont réalisées lors du dépôt de la pâte 10, les irrégularités de cette surface posent un problème de planéité.

Des contraintes analogues existent également dans d'autres applications, comme par exemple lors de la réalisation de cordons de scellement destinés à la solidarisation de capots ou de couches de protection pour des dispositifs MEMS, ou bien encore lors de la réalisation de couches de fonctionnalisation pour des capteurs et des dispositifs de test utilisés dans le domaine de la biologie et/ou de la chimie. Le document US 6 008 071 A concerne des méthodes de transfert de billes fusibles sur un circuit intégré, tel qu'un dispositif semi-conducteur de type « flip chip ».

### EXPOSÉ DE L'INVENTION

Un but de la présente invention est de proposer un procédé de dépôt localisé d'au moins un matériau sur au moins un élément ne présentant pas les inconvénients de l'art antérieur précédemment décrit, c'est-à-dire qui permette de déposer localement le matériau sur un élément individuel de petites dimensions tel qu'une puce électronique, et/ou pour déposer le matériau sur une surface irrégulière présentant des creux.

Pour cela, il est proposé un procédé de dépôt localisé d'au moins un matériau sur au moins un élément selon la revendication 1.

Dans ce procédé, le matériau à déposer localement est tout d'abord déposé sur un support qui ne correspond pas à l'élément sur lequel le matériau est destiné à être déposé et qui sert de support temporaire. La partie de l'élément sur lequel le matériau est destiné à être déposé est ensuite positionnée en contact avec le matériau. Un traitement thermique et/ou chimique est ensuite mis en œuvre afin d'augmenter la force d'adhérence du matériau contre la partie de l'élément. A la fin du traitement thermique et/ou chimique, l'adhérence du matériau contre la partie de l'élément est supérieure à celle du matériau contre la partie de la surface du support. Cette propriété est obtenue en choisissant judicieusement les matériaux formant la partie de la surface du support et la partie de l'élément contre lesquels le matériau est disposé. Ainsi, la séparation qui est ensuite réalisée entre l'élément et le support engendre une rupture à l'interface entre le matériau et la partie de la surface du support, avec le matériau qui reste solidaire de l'élément. Le matériau se retrouve donc bien déposé localement sur l'élément.

Ce procédé est particulièrement bien adapté pour être mis en œuvre avec des éléments individuels de petites tailles, par exemple des puces électroniques, qui sont indépendants les uns des autres. Ce procédé peut être mis en œuvre simultanément pour plusieurs éléments individuels. Ce procédé est également bien adapté pour déposer localement un matériau sur des éléments présentant des surfaces d'accueil du matériau irrégulières comprenant des creux puisqu'aucune sérigraphie n'est directement mise en œuvre sur ces surfaces d'accueil.

Ce procédé peut être mis en œuvre pour de nombreuses applications : réalisation de métallisations de type billes fusibles sur une ou plusieurs puces électroniques individuelles, réalisation de cordons de scellement destinés à la solidarisation de capots ou de couches de protection pour des dispositifs MEMS, réalisation d'interconnexions électriques et/ou mécaniques, réalisation de couches de fonctionnalisation pour des capteurs et des dispositifs de test utilisés dans le domaine de la biologie et/ou de la chimie.

Dans tout le document, le terme « bille » est utilisé pour désigner des microbilles de dimensions micrométriques, ou des billes de plus grandes dimensions.

Le traitement thermique correspond à au moins un recuit à une température supérieure ou égale à la température de fusion du matériau.

Le dépôt de la portion du matériau sur la partie de la surface du support peut être réalisé par sérigraphie à travers un écran comportant au moins une ouverture déterminant, lors du positionnement de l'écran sur la surface du support, l'emplacement de la partie de la surface du support.

La partie de l'élément peut former un creux par rapport au reste d'une surface de l'élément au niveau de laquelle se trouve ladite partie de l'élément.

La partie de la surface du support peut comporter un marquage en relief. Ainsi, lors de la désolidarisation entre le matériau déposé et la partie de la surface du support, un motif inverse à celui du marquage est reporté sur la surface du matériau qui est détachée du support. Ce marquage peut servir à réaliser des logos ou des poinçons permettant d'identifier ou d'authentifier l'élément.

Le procédé est tel que :
- le traitement thermique correspond à un traitement thermique mis en œuvre à une température supérieure ou égale à la température de fusion du matériau ;
- la partie de la surface du support est telle qu'un angle de contact entre le matériau à l'état liquide et la partie de la surface du support a une valeur θ_{C1} ;
- la partie de l'élément est telle qu'un angle de contact entre le matériau à l'état liquide et la partie de l'élément a une valeur θ_{C2} < θ_{C1}.

Lors du traitement thermique, le matériau traité change de phase et passe à l'état liquide. Ces valeurs des angles de contact θ_{C1} et θ_{C2} sont obtenues en choisissant judicieusement les matériaux formant la partie de la surface du support et la partie de l'élément et qui sont en contact avec le matériau à l'état liquide. Avec de tels angles de contact, après le retour à l'état solide du matériau, l'adhérence du matériau contre la partie de l'élément est bien supérieure à celle du matériau contre la partie de la surface du support.

Le procédé est tel que :
- le matériau est un matériau métallique de brasure, et
- le traitement thermique mis en œuvre est un recuit.

De plus, le matériau métallique de brasure comporte au moins l'un des métaux suivants : étain, indium, argent, et la partie de la surface du support peut comporter un oxyde métallique et la partie de l'élément comporte au moins l'un des métaux suivants : aluminium, cuivre, or. De tels matériaux permettent d'obtenir, du côté de l'élément, un matériau dit « mouillable » par le matériau métallique de brasure et, du côté du support, un matériau dit « non mouillable » par le matériau métallique de brasure.

Le procédé peut comporter en outre, entre le dépôt de la portion du matériau sur la partie de la surface du support et le positionnement de la partie de l'élément contre la portion du matériau, la mise en œuvre d'un recuit initial de la portion de matériau. Ce recuit initial permet de supprimer une partie des solvants présents dans le matériau déposé sur la partie de la surface du support.

Selon un premier mode de réalisation, l'élément peut correspondre à une puce électronique.

De plus, le procédé peut être tel que :
- plusieurs portions de matériau sont déposées sur le support,
- les parties de la puce électronique disposées contre les portions de matériau correspondent à des plots de contact électrique, et
- après la mise en œuvre du traitement thermique, les portions de matériau forment des métallisations de type billes fusibles.

Selon un deuxième mode de réalisation, le procédé peut être tel que :
- l'élément correspond à une couche de protection ou un capot adapté pour enfermer ou protéger au moins un dispositif de type MEMS dans une cavité, et
- après la mise en œuvre du traitement thermique, la portion de matériau forme un cordon de scellement solidarisé à la couche de protection ou au capot.

Dans tout le présent document, l'expression « dispositif MEMS » est utilisée pour désigner des dispositifs MEMS ou NEMS (« NanoElectroMechanical System » ou nanosystème électro-mécanique) ou MOEMS (« Micro-Opto-ElectroMechanical System » ou microsystème opto-électro-mécanique) ou NOEMS (« Nano-Opto-ElectroMechanical System » ou nanosystème opto-électro-mécanique) ou tout autre dispositif électronique ou microélectronique destiné à être enfermé ou protégé dans une cavité.

Selon un procédé apparenté n'entrant pas dans le cadre de l'invention revendiquée, le procédé peut être tel que :
- le matériau est un matériau organique, et
- le traitement thermique et/ou chimique comprend la mise en œuvre d'une déshydratation et/ou d'un traitement thermique de type trempe et/ou d'une congélation.

Dans ce cas, l'élément peut correspondre à un dispositif de test ou un capteur destiné à des applications biologiques et/ou chimiques, et la portion de matériau forme, à la fin du traitement thermique et/ou chimique, une couche de fonctionnalisation.

Selon un procédé apparenté n'entrant pas dans le cadre de l'invention revendiquée, le procédé peut être tel que :
- le matériau est un polymère, et
- le traitement thermique et/ou chimique correspond à une polymérisation comprenant la mise en œuvre d'une illumination par un faisceau laser et/ou une insolation par un rayonnement UV ou infrarouge du matériau.

De manière générale, le procédé selon l'invention peut être mis en œuvre simultanément pour plusieurs éléments.

De plus, les éléments peuvent avoir des épaisseurs différentes.

### BRÈVE DESCRIPTION DES DESSINS

La présente invention sera mieux comprise à la lecture de la description d'exemples de réalisation donnés à titre purement indicatif et nullement limitatif en faisant référence aux dessins annexés sur lesquels :
- les figures 1 à 4 représentent un exemple de procédé de réalisation de métallisations de type billes fusibles selon l'art antérieur;
- les figures 5 à 10 représentent un exemple de procédé de dépôt localisé d'au moins un matériau sur au moins un élément selon un premier mode de réalisation ;
- les figures 11 à 15 représentent un exemple de procédé de dépôt localisé d'au moins un matériau sur au moins un élément selon un deuxième mode de réalisation.

Des parties identiques, similaires ou équivalentes des différentes figures décrites ci-après portent les mêmes références numériques de façon à faciliter le passage d'une figure à l'autre.

Les différentes parties représentées sur les figures ne le sont pas nécessairement selon une échelle uniforme, pour rendre les figures plus lisibles.

Les différentes possibilités (variantes et modes de réalisation) doivent être comprises comme n'étant pas exclusives les unes des autres et peuvent se combiner entre elles.

### EXPOSÉ DÉTAILLÉ DE MODES DE RÉALISATION PARTICULIERS

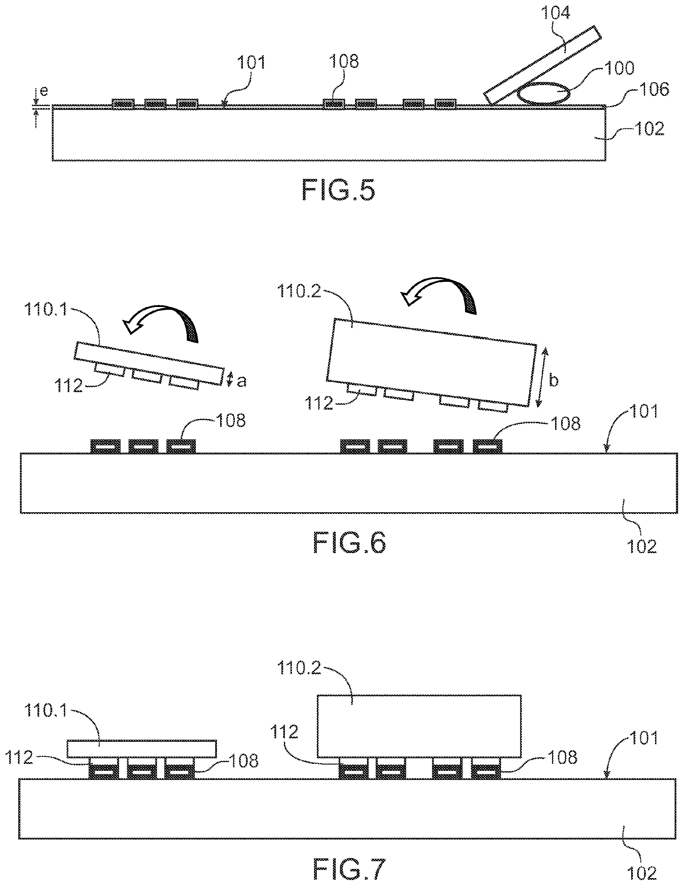

Un procédé de dépôt localisé d'au moins un matériau sur au moins un élément selon un premier mode de réalisation est décrit ci-dessous en lien avec les figures 5 à 10. Dans ce premier mode de réalisation particulier, ce procédé de dépôt est mis en œuvre pour réaliser des métallisations de type billes fusibles sur des puces électroniques.

Comme représenté sur la figure 5, de la pâte à braser 100 comportant du matériau à déposer localement, ici du matériau fusible, ou matériau métallique de brasure, est étalée sur au moins une partie d'une surface 101 d'un support 102. Le matériau à déposer correspond par exemple à de l'étain ou de l'indium ou de l'argent ou un alliage comportant au moins l'un de ces métaux. Le support 102 correspond par exemple à un substrat semi-conducteur, ou tout autre support adapté pour recevoir le dépôt du matériau 100.

La pâte à braser 100 est étalée par exemple avec une racle 104 à travers un écran de sérigraphie 106. Des ouvertures formées à travers l'écran de sérigraphie 106 déterminent, lors du positionnement de l'écran de sérigraphie 106 sur la surface 101 du support 102, l'emplacement des parties de la surface 101 du support 102 sur lesquelles de la pâte à braser 100 est déposée. La référence 108 désigne les portions de matériau déposées sur le support 102. L'épaisseur « e » du masque 106, qui correspond à l'épaisseur des portions 108 de matériau déposées, est par exemple comprise entre environ 40 µm et 500 µm.

Les parties de la surface 101 du support 102 sur lesquelles les portions 108 de matériau sont déposées comprennent un matériau tel que lorsque le matériau des portions 108 est à l'état liquide, l'angle de contact entre le matériau à l'état liquide et les parties de la surface 101 du support 102 sur lesquelles les portions 108 sont déposées a une valeur θ_{C1}. Il est possible que toute la surface 101 du support 102 au niveau de laquelle le matériau est déposé, c'est-à-dire toute la face du support 102 du côté de laquelle le matériau est déposé, comporte un tel matériau.

Ce matériau des parties de la surface 101 du support 102 sur lequel les portions 108 sont déposées est choisi tel qu'il soit moins « mouillant », ou comporte une plus faible mouillabilité, que celui du ou des éléments (correspondant à des puces électroniques dans le premier mode de réalisation décrit ici) auxquels les portions 108 sont destinées à être déposées localement à l'issue du procédé. Ainsi, le matériau de ladite ou desdites parties de la surface 101 du support 102 peut être tel qu'un angle de contact entre le matériau des portions 108 à l'état liquide et ladite ou lesdites parties de la surface 101 du support 102 a une valeur θ_{C1}, et le matériau de la ou des parties des éléments auxquels les portions 108 sont destinées à être déposées localement à l'issue du procédé peut être tel qu'un angle de contact entre le matériau des portions 108 à l'état liquide et ladite ou lesdites parties de ces éléments a une valeur θ_{C2} < θ_{C1}.

Lorsque le matériau déposé correspond à l'un des matériaux de brasure précédemment mentionnés, le matériau de la ou des parties de la surface 101 du support 102 peut correspondre à un oxyde métallique tel que de l'oxyde de cuivre. Par exemple, dans l'exemple de réalisation décrit ici, la surface 101 du support 102 est formée d'une couche d'oxyde métallique. Lorsque le matériau métallique correspond à un oxyde métallique, sa mouillabilité peut être ajustée via les paramètres de mise en œuvre de l'oxydation formant ce matériau, par exemple par l'ajustement de la durée d'étuvage ou du traitement plasma de cette oxydation.

De manière optionnelle, un recuit initial des portions 108 de matériau à une température faisant passer le matériau 100 à l'état liquide, c'est-à-dire à une température supérieure ou égale à la température de fusion du matériau des portions 108, est mis en œuvre. Ce recuit initial permet d'enlever une partie des solvants présents dans le matériau déposé, et est mis en œuvre par exemple à une température comprise entre environ 220°C et 260°C lorsque le matériau déposé correspond à l'un des matériaux de brasure précédemment mentionnés, et pendant une durée comprise entre environ 5 et 15 minutes.

L'écran 106 est retiré et un ou plusieurs éléments 110 sont ensuite disposés contre les portions 108. Dans le premier mode de réalisation décrit ici, plusieurs éléments référencés 110.1 et 110.2, correspondant à des puces électroniques, sont disposés contre les portions 108 (voir figures 6 et 7).

Les puces 110.1 et 110.2 comportent chacune, sur une de leurs faces, des plots de connexion 112 formant les parties contre lesquelles les métallisations de type billes fusibles sont destinées à être réalisées. Ces plots de connexion 112 comportent un matériau tel que lorsque le matériau fusible est à l'état liquide, l'angle de contact entre le matériau fusible à l'état liquide et les plots de connexion 112 a une valeur θ_{C2} < θ_{C1}. Lorsque le matériau 100 correspond à l'un des matériaux de brasure précédemment mentionnés, un tel matériau peut correspondre à de l'aluminium, du cuivre ou de l'or ou un alliage comportant au moins l'un de ces métaux. En outre, les plots de connexion 112 présents sur les puces électroniques 110.1 et 110.2 sont disposés selon un agencement compatible avec celui des portions 108, c'est-à-dire tels que lorsque les puces électroniques 110.1 et 110.2 sont mises en place contre les portions 108, ces portions 108 se retrouvent en contact avec les plots de connexion 112.

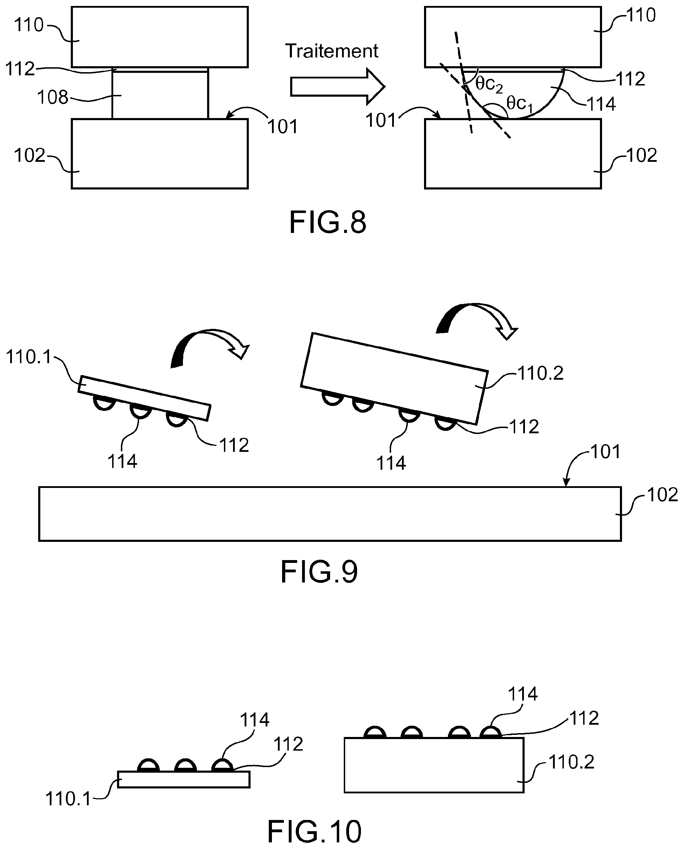

Comme représenté sur la figure 8, un traitement thermique et/ou chimique des portions 108 de matériau est ensuite mis en œuvre afin d'engendrer à la fin de ce traitement, une augmentation de l'adhérence du matériau contre les plots de connexion 112. Dans le premier mode de réalisation décrit ici, ce traitement correspond à un traitement thermique, et plus particulièrement un recuit mis en œuvre dans un four à passage à une température supérieure ou égale à la température de fusion du matériau des portions 108. Ce traitement thermique est mis en œuvre par exemple à une température comprise entre environ 220°C et 260°C lorsque le matériau des portions 108 correspond à l'un des matériaux de brasure précédemment mentionnés, et pendant une durée comprise entre environ 5 min. et 15 min (durée complète incluant la montée et la descente en température). Au cours de ce traitement thermique, les portions 108 peuvent être exposées à une température comprise entre environ 220°C et 260°C pendant une durée de l'ordre d'une minute. Les portions de matériau obtenues à la fin du recuit, après la solidification du matériau déposé, portent la référence 114.

Les matériaux de la ou des parties du ou des éléments sur lesquelles le matériau est destiné à être déposé localement, c'est-à-dire le matériau des plots de connexion 112 dans l'exemple de réalisation décrit en lien avec les figures 5 à 10, et de la ou des parties de la surface 101 du support 102 sur lesquelles le matériau est initialement déposé sont choisis tels que lors du recuit mis en œuvre, les angles de contact θ_{C1} et θ_{C2} sont tels que θ_{C2} < θ_{C1}. Ces angles de contact sont visibles sur la figure 8. Avec de tels angles de contact, à la fin du recuit, l'adhérence du matériau des portions 114 contre les plots de connexion 112 est supérieure à celle du matériau des portions 114 contre les parties de la surface 101 du support 102 en raison notamment de la plus grande surface de contact obtenue entre le matériau des portions 114 et les plots de connexion 112 par rapport à celle entre le matériau des portions 114 et la surface 101 du support 102.

A titre d'exemple, lorsque le matériau à déposer correspond à une brasure comprenant un alliage d'étain (composition en étain supérieure à 96 %), le matériau de la ou des parties de la surface 101 du support 102 sur lesquelles le matériau est initialement déposé peut être choisi tel que l'adhérence entre le matériau des portions 114 et les parties de la surface 101 du support 102 soit inférieure à environ 3 kg/mm² lorsque cette valeur est mesurée en test de cisaillement, après la mise en œuvre du recuit, selon la méthodologie décrite dans les publications suivantes : « Effect of intermetallic compound thickness on shear strength of 25 µm diameter Cu-pillars » de Julien Bertheau et al., Intermetallics, vol.51, août 2014, pages 37-47, et « Effects of bump size on deformation and fracture behavior of Sn3.0Ag0.5Cu/Cu solder joints during shear testing » de Yanhong Tian et al., Materials Science and Engineering: A, vol. 529, 25 novembre 2011, pages 468-478.

Dans le premier mode de réalisation décrit ici, les portions 114 obtenues correspondent à des métallisations de type billes fusibles. Le diamètre de ces billes est par exemple compris entre environ 40 µm et 500 µm.

Comme représenté sur la figure 9, les puces électroniques 110.1 et 110.2 sont retirées et séparées du support 102, avantageusement de manière collective. Etant donné que l'adhérence des portions 114 contre les plots de connexion 112 est supérieure à celle des portions 114 contre le support 102, les portions 114 restent solidaires des puces électroniques 110.1 et 110.2 et se détachent du support 102.

Les puces électroniques 110.1 et 110.2 obtenues et représentées sur la figure 10 sont prêtes à être reportées par « flip-chip » sur un autre support.

De manière avantageuse, les parties du support 102 sur lesquelles les portions 108 sont déposées comportent un marquage en relief. Ainsi, lors de la désolidarisation entre les portions 114 et le support 102, ce marquage se retrouve (selon un motif inversé) sur la surface du matériau des portions 114 qui était en contact avec le support 102. Ce marquage peut servir par exemple à réaliser des logos ou des poinçons permettant d'identifier ou d'authentifier le ou les éléments 110.

Le procédé décrit ci-dessus s'applique avantageusement pour un dépôt localisé du matériau 100 sur une ou plusieurs parties d'un ou plusieurs éléments 110, correspondant par exemple à des puces électroniques, formant un ou des creux par rapport au reste de la surface du ou des élément 100 au niveau de laquelle se trouve(nt) cette ou ces parties. Etant donné que la sérigraphie du matériau à déposer n'est pas réalisée directement sur cette surface irrégulière et que le matériau est « transféré » du support 102 à ou aux éléments 110 via la mise en œuvre du traitement thermique et/ou chimique, ce transfert s'opère sans difficulté sur cette surface irrégulière.

Le procédé de dépôt localisé décrit précédemment peut être mis en œuvre pour des applications autres que la réalisation de métallisations de type billes fusibles.

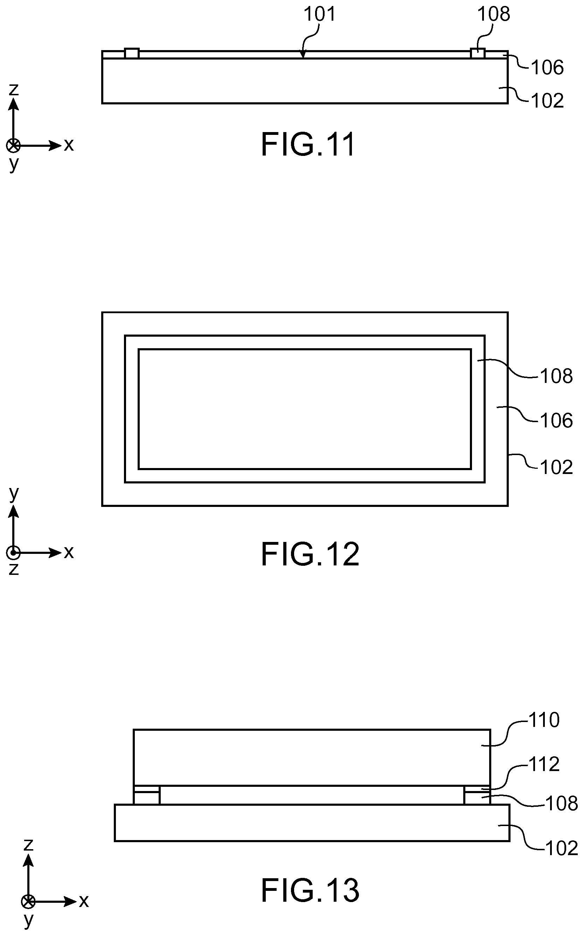

Un procédé de dépôt localisé d'au moins un matériau sur au moins un élément selon un deuxième mode de réalisation est décrit ci-dessous en lien avec les figures 11 à 15. Dans ce deuxième mode de réalisation, ce procédé de dépôt est mis en œuvre pour réaliser un cordon de scellement d'un capot ou d'une couche de protection d'un dispositif de type MEMS.

Sur les figures 11 et 12, comme dans le premier mode de réalisation, le matériau est déposé par sérigraphie sur le support 102. Dans ce deuxième mode de réalisation, le matériau 100 est déposé sous la forme d'une portion 108 comportant par exemple un motif de contour fermé et destiné à former un cordon de scellement. Le matériau 100 correspond ici à un matériau fusible par exemple similaire à celui précédemment décrit pour le premier mode de réalisation. De plus, au moins la ou les parties de la surface 101 du support 102 (éventuellement toute la surface 101 du support 102) sur lesquelles le matériau de la portion 108 est déposé comprend un matériau dit « non mouillable », correspondant par exemple à l'un des exemples de matériaux précédemment décrits pour le premier mode de réalisation.

Comme dans le premier mode de réalisation, de manière optionnelle, un recuit initial peut être mis en œuvre à une température supérieure ou égale à la température de fusion du matériau 100 afin de supprimer les solvants présents dans le matériau déposé.

L'écran 106 est retiré et un élément 110 correspondant à une couche de protection ou un capot est positionné contre la portion 108 (figure 13). Comme pour les puces électroniques précédemment décrites dans le premier mode de réalisation, l'élément 110 formant le capot ou la couche de protection comporte, sur la face destinée à recevoir la portion 108, un matériau « mouillable » correspondant par exemple à l'un des exemples de matériaux précédemment mentionnés dans le premier mode de réalisation. L'élément 110 peut donc comporter une région 112 de matériau similaire à celui des plots de contact 112 et dont la forme et les dimensions correspondent à ceux du cordon de scellement destiné à être réalisé.

Un recuit est ensuite mis en œuvre à une température supérieure ou égale à la température de fusion du matériau de la portion 108. Lors de ce recuit, le matériau de la portion 108 passe à l'état liquide en formant, comme dans le premier mode de réalisation, des angles de contact θ_{C1} et θ_{C2} tels que θ_{C2} < θ_{C1}. La portion 114 obtenue à la fin du recuit forme un cordon de scellement dont l'adhérence contre l'élément 110 est supérieure à celle contre le support 102.

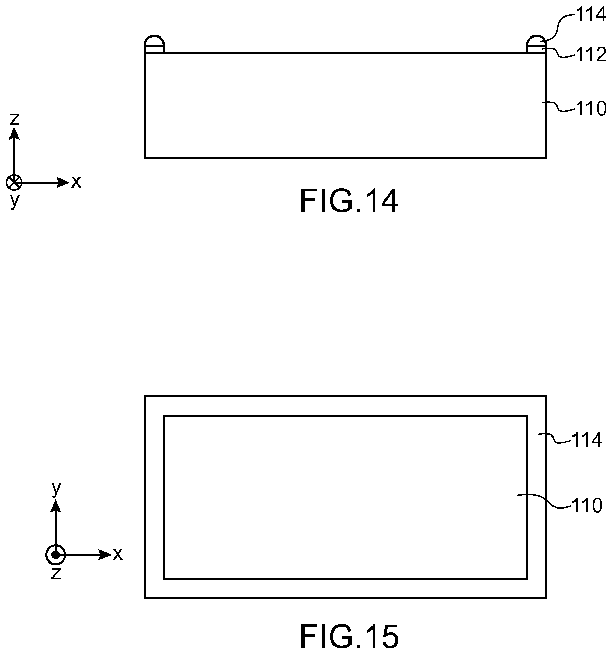

L'élément 110 est retiré, ce qui sépare la portion 114 vis-à-vis du support 102 (figures 14 et 15). Le capot 110 obtenu est prêt à être reporté pour fermer par exemple une cavité dans laquelle est disposé un dispositif MEMS.

Comme dans le premier mode de réalisation, le support 102 peut comporter un marquage en relief dont le motif se retrouve alors sur la surface du matériau de la portion 114 qui était en contact avec le support 102.

Pour d'autres applications n'entrant pas dans le cadre de l'invention revendiquée, le procédé peut être mis en œuvre pour réaliser un dépôt localisé d'au moins un matériau organique, correspondant par exemple à un composé comprenant des liants organiques. Dans ce cas, le traitement thermique et/ou chimique mis en œuvre correspond à une étape de séchage et/ou de déshydratation du matériau. Après avoir réalisé la séparation entre le ou les éléments 110 (par exemple des puces) sur lesquels le matériau a été déposé localement et le support 102, les éléments 110 peuvent être soumis à un traitement thermique ultérieur permettant de stabiliser le matériau déposé localement et/ou obtenir le composé désiré.

Dans ce cas, le procédé est avantageusement mis en œuvre pour fonctionnaliser un capteur, comme décrit dans le document « Optimisation du procédé de sérigraphie pour la réalisation de capteurs de gaz en couche épaisse », thèse de doctorat soutenue par Béatrice Rivière à Saint-Etienne le 4 février 2004, p34, partie B.1.1 « Principe de la sérigraphie ».

Pour d'autres applications n'entrant pas dans le cadre de l'invention revendiquée, le procédé peut être mis en œuvre pour réaliser un dépôt localisé d'au moins un matériau polymère. De tels matériaux polymères correspondent par exemple à des résines d'encapsulation ou d'enrobage à base d'époxy, appelées « Glob Top », qui sont notamment utilisées pour protéger des composants, par exemple électroniques, vis-à-vis de l'environnement extérieur. Dans ce cas, le traitement thermique et/ou chimique mis en œuvre correspond à une polymérisation obtenue par exemple en mettant en œuvre une insolation UV à travers le support 102 qui doit être transparent au rayonnement utilisé pour la polymérisation. Cette polymérisation permet de rigidifier et fixer la composition chimique du matériau déposé. Le support 102 est ensuite séparé du ou des composants sur lesquels la résine polymérisée a été déposée et qui reste solidaire du ou des composants. En variante, suivant la nature du polymère à déposer, la polymérisation peut être également réalisée par un faisceau laser et/ou une insolation par un rayonnement infrarouge.

Pour d'autres applications n'entrant pas dans le cadre de l'invention revendiquée, le procédé peut être mis en œuvre pour réaliser des dispositifs de test destinés à des applications biologiques et/ou chimiques. Par exemple, ce procédé peut servir à déposer localement, sur des éléments correspondant à des puces micro-fluidiques par exemple à base de polydiméthylsiloxane ou PDMS, un matériau sous forme de gel ou liquide, comprenant par exemple des protéines, à analyser. Ce matériau peut être déposé sur le support 102 par sérigraphie ou par une autre méthode (pipette, seringue). Ensuite, une ou plusieurs puces micro-fluidiques 110, comportant des zones spécifiques pour que le matériau sous forme de gel ou liquide adhère après un traitement thermique et/ou chimique de type congélation et/ou trempe, sont positionnées sur le support 102, dans les zones où la dispense du matériau a été réalisée. Le traitement thermique et/ou chimique est ensuite mis en œuvre, ce qui permet de faire adhérer le matériau aux puces 110. Le support 102 est ensuite retiré, et les puces 110 sont prélevées. A l'issue du procédé, pour réaliser les analyses du matériau déposé sur les puces 110, un traitement thermique est par exemple mis en œuvre afin que le matériau retrouve son état de gel ou de liquide, ce qui permet de réaliser une du matériau, par exemple des protéines contenues dans le liquide ou le gel.

### Liste des documents cités

Julien Bertheau et al., « Effect of intermetallic compound thickness on shear strength of 25 µm diameter Cu-pillars », Intermetallics, vol. 51, août 2014, pages 37-47.
Yanhong Tian et al., « Effects of bump size on deformation and fracture behavior of Sn3.0Ag0.5Cu/Cu solder joints during shear testing », Materials Science and Engineering: A, vol. 529, 25 novembre 2011, pages 468-478.
Béatrice Rivière, thèse de doctorat intitulée « Optimisation du procédé de sérigraphie pour la réalisation de capteurs de gaz en couche épaisse », Saint-Etienne, 4 février 2004, p.34, partie B.1.1 « Principe de la sérigraphie ».

## Revendications

1. Procédé de dépôt localisé d'au moins un matériau sur au moins un élément (110), comprenant la mise en œuvre des étapes suivantes :
- dépôt d'au moins une portion (108) du matériau sur au moins une partie d'une surface (101) d'un support (102) ;
- positionnement d'au moins une partie (112) de l'élément (110) contre la portion (108) du matériau ;
- traitement thermique, correspondant à un recuit mis en œuvre à une température supérieure ou égale à la température de fusion du matériau, de la portion (108) de matériau augmentant, à la fin du traitement thermique, la force d'adhérence du matériau contre la partie (112) de l'élément (110), les matériaux de la partie (112) de l'élément (110) et de la partie de la surface (101) du support (102) étant choisis tels que l'adhérence du matériau contre la partie (112) de l'élément (110) soit, à la fin du traitement thermique, supérieure à celle du matériau contre la partie de la surface (101) du support (102) ;
- séparation de l'élément (110) et du support (102) au niveau de l'interface entre le matériau et la partie de la surface (101) du support (102), le matériau restant solidaire de la partie (112) de l'élément (110),
et dans lequel :
- la partie de la surface (101) du support (102) est telle qu'un angle de contact entre le matériau à l'état liquide et la partie de la surface (101) du support (102) a une valeur θ_{C1} ;
- la partie (112) de l'élément (110) est telle qu'un angle de contact entre le matériau à l'état liquide et la partie (112) de l'élément (110) a une valeur θ_{C2} < θ_{C1} ;
- le matériau correspond à un matériau métallique de brasure comportant au moins l'un des métaux suivants : étain, indium, argent, et
- la partie (112) de l'élément (110) comporte au moins l'un des métaux suivants : aluminium, cuivre, or;
**caractérisé en ce que** la partie de la surface (101) du support (102) comporte un oxyde métallique.

2. Procédé selon la revendication 1, dans lequel le dépôt de la portion (108) du matériau sur la partie de la surface (101) du support (102) est réalisé par sérigraphie à travers un écran (106) comportant au moins une ouverture déterminant, lors du positionnement de l'écran (106) sur la surface (101) du support (102), l'emplacement de la partie de la surface (101) du support (102).

3. Procédé selon l'une des revendications précédentes, dans lequel la partie (112) de l'élément (110) forme un creux par rapport au reste d'une surface de l'élément (110) au niveau de laquelle se trouve ladite partie (112) de l'élément (110).

4. Procédé selon l'une des revendications précédentes, dans lequel la partie de la surface (101) du support (102) comporte un marquage en relief.

5. Procédé selon l'une des revendications précédentes, comportant en outre, entre le dépôt de la portion (108) du matériau sur la partie de la surface (101) du support (102) et le positionnement de la partie (112) de l'élément (110) contre la portion (108) du matériau, la mise en œuvre d'un recuit initial de la portion (108) de matériau.

6. Procédé selon l'une des revendications précédentes, dans lequel le matériau a une adhérence sur la surface (101) du support (102) inférieure à 3 kg/mm².

7. Procédé selon l'une des revendications précédentes, dans lequel l'élément (110) correspond à une puce électronique.

8. Procédé selon la revendication 7, dans lequel :
- plusieurs portions (108) de matériau sont déposées sur le support (102),
- les parties (112) de la puce électronique (110) disposées contre les portions (108) de matériau correspondent à des plots de contact électrique, et
- après la mise en œuvre du traitement thermique, les portions (114) de matériau forment des métallisations de type billes fusibles.

9. Procédé selon l'une des revendications 1 à 6, dans lequel :
- l'élément (110) correspond à une couche de protection ou un capot adapté pour enfermer ou protéger au moins un dispositif de type MEMS dans une cavité, et
- après la mise en œuvre du traitement thermique, la portion (114) de matériau forme un cordon de scellement solidarisé à la couche de protection ou au capot.

10. Procédé selon l'une des revendications précédentes, dans lequel le procédé est mis en œuvre simultanément pour plusieurs éléments (110.1, 110.2).

11. Procédé selon la revendication 10, dans lequel les éléments (110.1, 110.2) ont des épaisseurs différentes.

## Patentansprüche

1. Verfahren zur lokalisierten Ablagerung von mindestens einem Material auf mindestens einem Element (110), umfassend die Durchführung folgender Schritte:
- Ablagern mindestens eines Anteils (108) des Materials auf mindestens einem Teil einer Oberfläche (101) eines Trägers (102);
- Positionieren mindestens eines Teils (112) des Elements (110) gegen den Anteil (108) des Materials;
- Wärmebehandlung, entsprechend einem Glühen, die bei einer Temperatur durchgeführt wird, die höher oder gleich der Schmelztemperatur des Materials ist, des Anteils (108) von Material, wodurch am Ende der Wärmebehandlung die Haftkraft des Materials gegen den Teil (112) des Elements (110) erhöht wird, wobei die Materialien des Teils (112) des Elements (110) und des Teils der Oberfläche (101) des Trägers (102) so gewählt sind, dass die Haftung des Materials an dem Teil (112) des Elements (110) am Ende der Wärmebehandlung größer ist als die Haftung des Materials an dem Teil der Oberfläche (101) des Trägers (102);
- Trennung des Elements (110) und des Trägers (102) an der Schnittstelle zwischen dem Material und dem Teil der Oberfläche (101) des Trägers (102), wobei das Material fest mit dem Teil (112) des Elements (110) verbunden bleibt,
und wobei:
- der Teil der Oberfläche (101) des Trägers (102) so ist, dass ein Kontaktwinkel zwischen dem flüssigen Material und dem Teil der Oberfläche (101) des Trägers (102) einen Wert θ_{C1} hat;
- der Teil (112) des Elements (110) so ist, dass ein Kontaktwinkel zwischen dem flüssigen Material und dem Teil (112) des Elements (110) einen Wert θ_{C2} < θ_{C1} hat;
- das Material einem metallischen Lötmaterial entspricht, das mindestens eines der folgenden Metalle aufweist: Zinn, Indium, Silber, und
- der Teil (112) des Elements (110) mindestens eines der folgenden Metalle aufweist: Aluminium, Kupfer, Gold;
**dadurch gekennzeichnet, dass** der Teil der Oberfläche (101) des Trägers (102) ein Metalloxid aufweist.

2. Verfahren nach Anspruch 1, wobei die Ablagerung des Anteils (108) des Materials auf dem Teil der Oberfläche (101) des Trägers (102) durch einen Siebdruck durch einen Bildschirm (106) erfolgt, der mindestens eine Öffnung aufweist, die bei der Positionierung des Bildschirms (106) auf der Oberfläche (101) des Trägers (102) die Position des Teils der Oberfläche (101) des Trägers (102) bestimmt.

3. Verfahren nach einem der vorhergehenden Ansprüche, wobei der Teil (112) des Elements (110) eine Vertiefung gegenüber dem Rest einer Oberfläche des Elements (110) bildet, an der sich der Teil (112) des Elements (110) befindet.

4. Verfahren nach einem der vorhergehenden Ansprüche, wobei der Teil der Oberfläche (101) des Trägers (102) eine Reliefmarkierung aufweist.

5. Verfahren nach einem der vorhergehenden Ansprüche, ferner aufweisend, zwischen dem Ablagern des Anteils (108) des Materials auf dem Teil der Oberfläche (101) des Trägers (102) und dem Positionieren des Teils (112) des Elements (110) gegen den Anteil (108) des Materials, das Durchführen eines anfänglichen Glühens des Anteils (108) des Materials.

6. Verfahren nach einem der vorhergehenden Ansprüche, wobei das Material eine Haftung auf der Oberfläche (101) des Trägers (102) von weniger als 3 kg/mm² hat.

7. Verfahren nach einem der vorhergehenden Ansprüche, wobei das Element (110) einem elektronischen Chip entspricht.

8. Verfahren nach Anspruch 7, wobei:
- mehrere Anteile (108) von Material auf dem Träger (102) abgelegt sind,
- die Teile (112) des elektronischen Chips (110), die gegen die Anteile (108) von Material angeordnet sind, elektrischen Kontaktflächen entsprechen, und
- nach dem Durchführen der Wärmebehandlung die Anteile (114) von Material Metallisierungen vom Schmelzkugel-Typ bilden.

9. Verfahren nach einem der Ansprüche 1 bis 6, wobei:
- das Element (110) einer Schutzschicht oder Abdeckung entspricht, die geeignet ist, mindestens eine Vorrichtung des MEMS-Typs in einem Hohlraum einzuschließen oder zu schützen, und
- nach dem Durchführen der Wärmebehandlung der Anteil (114) von Material eine Versiegelungsnaht bildet, die fest mit der Schutzschicht oder der Abdeckung verbunden ist.

10. Verfahren nach einem der vorhergehenden Ansprüche, wobei das Verfahren gleichzeitig für mehrere Elemente (110.1, 110.2) eingesetzt wird.

11. Verfahren nach Anspruch 10, wobei die Elemente (110.1, 110.2) unterschiedliche Dicken aufweisen.

## Claims

1. A method for localised deposition of at least one material over at least one element (110), comprising the implementation of the following steps:
- deposition of at least one portion (108) of the material over at least one portion of a surface (101) of a support (102);
- positioning of at least one portion (112) of the element (110) against the portion (108) of the material;
- heat treatment, corresponding to an annealing carried out at a temperature higher than or equal to the melting temperature of the material, of the material portion (108) increasing, at the end of the heat treatment, the adhesion force of the material against the portion (112) of the element (110), the materials of the portion (112) of the element (110) and of the portion of the surface (101) of the support (102) being selected such that the adhesion of the material against the portion (112) of the element (110) is, at the end of the heat treatment, higher than that of the material against the portion of the surface (101) of the support (102);
- separation of the element (110) and the support (102) at the interface between the material and the portion of the surface (101) of the support (102), the material remaining secured to the portion (112) of the element (110),
and wherein:
- the portion of the surface (101) of the support (102) is such that a contact angle between the material in the liquid state and the portion of the surface (101) of the support (102) has a value θ_{C1};
- the portion (112) of the element (110) is such that a contact angle between the material in the liquid state and the portion (112) of the element (110) has a value θ_{C2} < θ_{C1};
- the material corresponds to a metallic solder material including at least one of the following metals: tin, indium, silver, and
- the portion (112) of the element (110) includes at least one of the following metals: aluminium, copper, gold,
**characterised in that** the portion of the surface (101) of the support (102) includes a metal oxide.

2. The method according to claim 1, wherein the deposition of the portion (108) of the material over the portion of the surface (101) of the support (102) is carried out by screen-printing through a screen (106) including at least one opening determining, upon positioning the screen (106) on the surface (101) of the support (102), the location of the portion of the surface (101) of the support (102).

3. The method according to one of the preceding claims, wherein the portion (112) of the element (110) forms a recess with respect to the rest of a surface of the element (110) at which lies said portion (112) of the element (110).

4. The method according to one of the preceding claims, wherein the portion of the surface (101) of the support (102) includes a marking in relief.

5. The method according to one of the preceding claims, further including, between the deposition of the portion (108) of the material over the portion of the surface (101) of the support (102) and the positioning of the portion (112) of the element (110) against the portion (108) of the material, the implementation of an initial annealing of the material portion (108).

6. The method according to one of the preceding claims, wherein the material has an adhesion to the surface (101) of the support (102) lower than 3 kg/mm².

7. The method according to one of the preceding claims, wherein the element (110) corresponds to an electronic chip.

8. The method according to claim 7, wherein:
- several material portions (108) are deposited over the support (102),
- the portions (112) of the electronic chip (110) disposed against the material portions (108) correspond to electrical contact pads, and
- after the implementation of the heat treatment, the material portions (114) form of fusible-ball type metallisations.

9. The method according to one of claims 1 to 6, wherein:
- the element (110) corresponds to a protective layer or a cap adapted to enclose or protect at least one MEMS-type device in a cavity, and
- after the implementation of the heat treatment, the material portion (114) forms a sealing bead secured to the protective layer or to the cap.

10. The method according to one of the preceding claims, wherein the method is implemented simultaneously for several elements (110.1, 110.2).

11. The method according to claim 10, wherein the elements (110.1, 110.2) have different thicknesses.
